(19)

Europäisches
Patentamt
European
Patent Office
Office européen
des brevets

(11) **EP 4 269 689 A1**

(12) **EUROPEAN PATENT APPLICATION**
published in accordance with Art. 153(4) EPC

(43) Date of publication:
**01.11.2023   Bulletin 2023/44**

(21) Application number: **21915094.3**

(22) Date of filing: **15.12.2021**

(51) International Patent Classification (IPC):
*D21H 19/36* (2006.01)        *B32B 7/02* (2019.01)
*B32B 27/10* (2006.01)        *B32B 27/30* (2006.01)
*B32B 27/36* (2006.01)        *B32B 27/40* (2006.01)
*B65D 65/40* (2006.01)        *D21H 19/08* (2006.01)
*D21H 19/28* (2006.01)        *D21H 19/40* (2006.01)
*D21H 27/30* (2006.01)

(52) Cooperative Patent Classification (CPC):
**B32B 7/02; B32B 27/10; B32B 27/30; B32B 27/36;**
**B32B 27/40; B65D 65/40; D21H 19/08;**
**D21H 19/28; D21H 19/36; D21H 19/40;**
**D21H 27/30;** Y02W 90/10

(86) International application number:
**PCT/JP2021/046272**

(87) International publication number:
**WO 2022/145233 (07.07.2022 Gazette 2022/27)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority:  **28.12.2020   JP 2020218098**
                **28.12.2020   JP 2020218099**
                **28.12.2020   JP 2020218100**
                **15.03.2021   JP 2021041661**
                **15.03.2021   JP 2021041669**
                **15.03.2021   JP 2021041672**

(71) Applicant: **Oji Holdings Corporation**
**Chuo-ku**
**Tokyo 104-0061 (JP)**

(72) Inventors:
• **NOISHIKI, Yasutomo**
  **Tokyo 104-0061 (JP)**
• **SHAMOTO, Yuta**
  **Tokyo 104-0061 (JP)**
• **TANAKA, Miyoko**
  **Tokyo 104-0061 (JP)**
• **WAKABAYASHI, Misaki**
  **Tokyo 104-0061 (JP)**

(74) Representative: **Godemeyer Blum Lenze**
**Patentanwälte**
**Partnerschaft mbB - werkpatent**
**An den Gärten 7**
**51491 Overath (DE)**

(54) **BASE PAPER FOR METALLIZED PAPER AND METALLIZED PAPER**

(57)    An object of the present invention is to provide base paper for vapor deposition paper that can provide vapor deposition paper with excellent barrier properties. The base paper for vapor deposition paper according to the present invention includes: a paper substrate; and a clay coat layer and a resin layer in this order on at least one surface of the paper substrate. A surface of the resin layer has a wetting tension of 50 mN/m or more as measured in conformity with JIS K 6768:1999 and a print-surf surface roughness of 2.5 pm or less as measured in conformity with JIS P 8151:2004.

EP 4 269 689 A1

EP 4 269 689 A1

**Description**

Technical Field

The present invention relates to base paper for vapor deposition paper and vapor deposition paper using the same.

Background Art

In the related art, a packaging material including a paper substrate with a water vapor barrier property to block water vapor and a gas barrier property to block a gas other than water vapor, especially an oxygen barrier property to block oxygen, has been used for packaging food, a medical product, an electronic part, and the like in order to prevent quality degradation of contents.
Vapor deposition paper is obtained by forming a vapor deposition layer made of a metal or the like on the paper substrate, and is widely used for label paper with excellent design for sake and a soft drink, packaging paper for confectionery, and the like by taking advantage of glossiness thereof.
For example, PTL 1 discloses aluminum vapor deposition paper including an aluminum vapor deposition layer on base paper, in which a back surface of the base paper is treated such that a spontaneous polarization potential value of a surface of the vapor deposition layer falls within a specific range. For example, PTL 2 discloses a PTP packaging seal sheet obtained by sequentially forming, on one surface of tissue paper having a basis weight equal to or less than a specific value, a filler coating layer made of a polyolefin-based aqueous dispersion liquid, a vapor deposition thin film layer made of an inorganic oxide, and a heat seal resin layer.

Citation List

Patent Literature

PTL 1: JP 4-65599 A
PTL 2: JP 7-223686 A

Summary of Invention

As in PTLs 1 and 2, attempts have been made to improve barrier properties of a paper substrate against oxygen and water vapor by forming a vapor deposition layer, but the aluminum vapor deposition paper described in PTL 1 and the PTP packaging seal sheet described in PTL 2 have a poor gas barrier property.
The vapor deposition paper used as a food packaging material is required to have further improved barrier properties (oxygen barrier property and water vapor barrier property) from the viewpoint of food flavor retaining. Accordingly, an object of the present invention is to provide base paper for vapor deposition paper that can provide vapor deposition paper with excellent barrier properties.
The present invention relates to the following <1> to <11>.

<1> Base paper for vapor deposition paper, the base paper including:

a paper substrate; and
a clay coat layer and a resin layer in this order on at least one surface of the paper substrate, in which
a surface of the resin layer has a wetting tension of 50 mN/m or more as measured in conformity with JIS K 6768:1999 and a print-surf surface roughness of 2.5 pm or less as measured in conformity with JIS P 8151:2004.

<2> The base paper for vapor deposition paper according to <1>, in which

the surface of the resin layer has a Cobb water absorption of 0 g/m$^2$ or more and 10 g/m$^2$ or less at a temperature of 23°C and a contact time of 120 seconds, as measured in conformity with JIS P 8140:1998, and
a contact angle of the surface of the resin layer to water after 60 seconds is 65° or less as measured in conformity with JIS R 3257:1999.

<3> The base paper for vapor deposition paper according to <1> or <2>, in which

the surface of the resin layer has a surface specific electric resistance of $0.1 \times 10^{14}$ Ω or more and $10 \times 10^{14}$ Ω or less as measured in conformity with JIS C 2139:2008.

<4> The base paper for vapor deposition paper according to any one of <1> to <3>, in which
a biodegradation degree is 85% or more as measured in conformity with JIS K 6955:2017.

<5> The base paper for vapor deposition paper according to any one of <1> to <4>, in which
90 mass% or more of a component in the base paper for vapor deposition paper, excluding an inorganic material, is a biodegradable material.

<6> The base paper for vapor deposition paper according to any one of <1> to <5>, in which
the resin layer contains a water-suspendable polymer, and the water-suspendable polymer is one or more selected from the group consisting of a polyester-based resin and a polyurethane-based resin.

<7> The base paper for vapor deposition paper according to any one of <1> to <6>, in which
the clay coat layer contains an inorganic pigment and a binder, and the inorganic pigment has an aspect ratio of 50 or less and an average particle diameter of 5 pm or less.

<8> The base paper for vapor deposition paper according to <7>, in which
the inorganic pigment is kaolin.

<9> The base paper for vapor deposition paper according to <7> or <8>, in which
the binder contained in the clay coat layer is one or more selected from the group consisting of a styrene-butadiene-based resin, a styrene-(meth)acrylic resin, olefin-unsaturated carboxylic acid-based copolymer, and polylactic acid.

<10> The base paper for vapor deposition paper according to any one of <1> to <9>, in which
the clay coat layer and the resin layer are formed using an aqueous medium.

<11> Vapor deposition paper including:

the base paper for vapor deposition paper according to any one of <1> to <10>; and
a vapor deposition layer, an overcoat layer, and, if necessary, a heat seal layer in this order on the resin layer of the base paper for vapor deposition paper.

Description of Embodiments

Base paper for vapor deposition paper (also referred to as "base paper for vapor deposition") according to the present embodiment includes: a paper substrate; and a clay coat layer and a resin layer in this order on at least one surface of the paper substrate. A surface of the resin layer has a wetting tension of 50 mN/m or more as measured in conformity with JIS K 6768:1999 and a print-surf surface roughness of 2.5 pm or less as measured in conformity with JIS P 8151:2004. Vapor deposition paper produced using the base paper for vapor deposition paper according to the present embodiment has excellent barrier properties (oxygen barrier property and water vapor barrier property). The mechanism of achieving the effect is unclear, and is presumed as follows.

When the wetting tension of the surface of the resin layer is 50 mN/m or more, a polarity of the surface of the resin layer is increased, and an adhesion between the resin layer and a vapor deposition layer formed on the resin layer is improved. When the print-surf surface roughness of the surface of the resin layer is 2.5 pm or less, a vapor deposition layer with few defects can be formed on the resin layer. For this reason, the vapor deposition paper produced using the base paper for vapor deposition paper according to the present embodiment can exhibit excellent barrier properties. The mechanism described above is based on presumption, and the mechanism of achieving the effect of the present invention is not limited thereto.

Hereinafter, configurations and physical properties of the base paper for vapor deposition paper and the vapor deposition paper according to the present embodiment will be described in more detail. In the present description, a numerical range represented by "X to Y" means a numerical range including X as a lower limit value and Y as an upper limit value. When numerical ranges are described in stages, the upper limit and the lower limit of each numerical range can be freely combined. The term "(meth)acrylic" is a generic term including both acrylic and methacrylic.

The base paper for vapor deposition paper according to the present embodiment may include the clay coat layer and the resin layer in this order on one surface of the paper substrate, or may include the clay coat layer and the resin layer in this order on both surfaces of the paper substrate, and preferably includes the clay coat layer and the resin layer in this order on one surface of the paper substrate from the viewpoint of production efficiency.

<Paper Substrate>

Pulp constituting the paper substrate in the present embodiment preferably contains plant-derived pulp as a main component, and more preferably contains wood pulp as a main component. Examples of the wood pulp include hardwood pulp and softwood pulp. Examples of non-wood pulp include cotton pulp, hemp pulp, kenaf pulp, and bamboo pulp. A material other than a pulp fiber, such as a synthetic fiber including a rayon fiber and a nylon fiber, may also be blended as a secondary paper material as long as the effects of the present invention are not impaired.

A proportion of the hardwood pulp in the pulp constituting the paper substrate is preferably 65 mass% or more, more preferably 80 mass% or more, even more preferably 90 mass% or more, and still more preferably 95 mass% or more, and may be 100 mass%. When the proportion of the hardwood pulp in the pulp constituting the paper substrate is within the above range, recyclability is excellent.

Specific examples of the paper substrate used for the base paper for vapor deposition paper according to the present embodiment include bleached kraft paper, unbleached kraft paper, high-quality paper, a paperboard, liner paper, coated paper, one-side glazed paper, glassine paper, and graphene paper. Among them, bleached kraft paper, unbleached kraft paper, high-quality paper, and one-side glazed paper are preferred.

(Sizing Degree)

A sizing degree of the paper substrate is not particularly limited, and it is preferred to set a Stockigt sizing degree to 1 second or more in conformity with JIS P 8122:2004, from the viewpoint of improving the barrier properties. An upper limit thereof is not particularly limited, and is preferably 100 seconds or less, and more preferably 30 seconds or less. The sizing degree of the paper substrate can be controlled according to the type and content of an internal sizing agent, the type of pulp, a smoothing treatment, and the like.

Examples of the internal sizing agent include rosin-based, alkylketene dimer-based, alkenyl succinic anhydride-based, styrene-unsaturated carboxylic acid-based, higher fatty acid-based, and petroleum resin-based sizing agents. The content of the internal sizing agent is not particularly limited, and is preferably 0 parts by mass or more and preferably 3 parts by mass or less with respect to 100 parts by mass of the pulp in the paper substrate.

In addition to the internal sizing agent, other known internal additives may be added to the paper substrate. Examples of the internal additive include a filler, a paper strengthening agent, a yield improver, a pH adjuster, a drainage aid, a water-resistant agent, a softener, an antistatic agent, a defoaming agent, a slime control agent, a dye, and a pigment.

Examples of the filler include titanium dioxide, kaolin, talc, calcium carbonate (heavy calcium carbonate, light calcium carbonate), calcium sulfite, gypsum, calcined kaolin, white carbon, amorphous silica, delaminated kaolin, diatomaceous earth, magnesium carbonate, aluminum hydroxide, calcium hydroxide, magnesium hydroxide, and zinc hydroxide.

The paper substrate is obtained by papermaking a papermaking raw material containing a pulp slurry as a main component.

The pulp slurry is obtained from wood or non-wood raw material chips through steps such as digesting, washing, and bleaching. Methods used in a digesting step, a washing step, a bleaching step, and the like are not particularly limited. The pulp slurry obtained through the steps is further beaten in the presence of water.

In the papermaking of the paper substrate, a known wet papermaking machine can be appropriately selected and used. Examples of the papermaking machine include a Fourdrinier type papermaking machine, a gap former type papermaking machine, a cylinder type papermaking machine, and a short net type papermaking machine. A paper layer formed by the papermaking machine is preferably, for example, conveyed by felt and dried with a dryer. A multi-stage cylinder dryer may be used as a pre-dryer before drying with a dryer.

The paper substrate obtained as described above may be subjected to a surface treatment with a calendar to achieve uniformity in paper thickness and gloss profile. As the treatment with a calendar, a known calendar treatment machine can be appropriately selected and used.

(Basis Weight)

A basis weight of the paper substrate is not particularly limited, and is preferably 20 $g/m^2$ or more, more preferably 30 $g/m^2$ or more, and even more preferably 40 $g/m^2$ or more, and is preferably 500 $g/m^2$ or less, more preferably 400 $g/m^2$ or less, even more preferably 200 $g/m^2$ or less, and still more preferably 100 $g/m^2$ or less. The basis weight of the paper substrate is measured in conformity with JIS P 8124:2011.

(Thickness)

A thickness of the paper substrate is not particularly limited, and is preferably 5 pm or more, more preferably 10 pm or more, and even more preferably 20 pm or more, and is preferably 150 pm or less, more preferably 100 pm or less, and even more preferably 75 pm or less. The thickness of the paper substrate is measured in conformity with JIS P 8118:2014.

(Density)

From the viewpoint of moldability, a density of the paper substrate is preferably 0.5 g/cm$^3$ or more, and more preferably 0.6 g/cm$^3$ or more, and is preferably 1.2 g/cm$^3$ or less, and more preferably 1.0 g/cm$^3$ or less. The density of the paper substrate is calculated based on the basis weight and thickness of the paper substrate measured by the methods described above.

(Oken Type Smoothness)

From the viewpoint of obtaining a uniform vapor deposition layer, an Oken type smoothness of the paper substrate is preferably 5 seconds or more, and more preferably 10 seconds or more on at least a side where the vapor deposition layer is to be formed. An upper limit thereof is not particularly limited, and is preferably, for example, 1000 seconds or less. The Oken type smoothness of the paper substrate is measured in conformity with JIS P 8155:2010.

<Clay Coat Layer>

The base paper for vapor deposition paper according to the present embodiment includes the clay coat layer between the paper substrate and the resin layer to be described later. Accordingly, the paper substrate can be sealed and smoothed, and a flatter resin layer can be formed. As a result, a uniform vapor deposition layer can be formed in the case of forming vapor deposition paper to be described later, and the barrier properties can be improved.

The clay coat layer preferably contains an inorganic pigment and a binder, and more preferably mainly contains an inorganic pigment and a binder. The expression "the clay coat layer mainly contains an inorganic pigment and a binder" means that a total content of the inorganic pigment and the binder in the clay coat layer is, for example, 50 mass% or more, preferably 60 mass% or more, more preferably 70 mass% or more, even more preferably 80 mass% or more, still more preferably 90 mass% or more, and particularly preferably 95 mass% or more. An upper limit thereof is not particularly limited, and is 100 mass% or less. The clay coat layer may further contain an optional component in addition to the inorganic pigment and the binder.

(Inorganic Pigment)

The inorganic pigment contained in the clay coat layer is not particularly limited. Examples thereof include kaolin, talc, and mica, and kaolin is preferred. A content of the inorganic pigment in the clay coat layer is preferably 50 mass% or more, more preferably 60 mass% or more, and even more preferably 70 mass% or more, and is preferably 98 mass% or less, more preferably 90 mass% or less, and even more preferably 85 mass% or less.

<<Aspect Ratio>>

An aspect ratio of the inorganic pigment is preferably 50 or less from the viewpoint of forming a uniform and smooth resin layer and from the viewpoint of finely dispersing the inorganic pigment in the clay coat layer and improving disintegrability of the base paper for vapor deposition paper during recovery. A lower limit thereof is not particularly limited, and is preferably 1 or more. The aspect ratio can be measured by observation with an electron microscope or X-ray diffraction measurement.

<<Average Particle Diameter>>

An average particle diameter of the inorganic pigment is preferably 5 pm or less, more preferably 3 pm or less, and even more preferably 1 pm or less, from the viewpoint of forming a uniform and smooth resin layer and from the viewpoint of finely dispersing the inorganic pigment in the clay coat layer and improving the disintegrability of the base paper for vapor deposition paper during recovery. A lower limit thereof is not particularly limited, and is preferably 0.05 pm or more. The average particle diameter means a median diameter (d 50) measured by laser diffraction scattering particle size distribution measurement.

(Binder)

The binder contained in the clay coat layer is not particularly limited, and examples thereof include: a styrene-butadiene-based resin; a (meth)acrylic (co)polymer; a styrene-(meth)acrylic resin; an olefin-unsaturated carboxylic acid-based copolymer such as an ethylene-acrylic acid copolymer and an ethylene-methacrylic acid copolymer; and polylactic acid. Preferred are one or more selected from the group consisting of a styrene-butadiene-based resin, a styrene-(meth)acrylic resin, olefin-unsaturated carboxylic acid-based copolymer, and polylactic acid, and more preferred are one or more selected from the group consisting of a styrene-(meth)acrylic resin, an ethylene-(meth)acrylic acid copolymer, and polylactic acid.

The (meth)acrylic (co)polymer is a (co)polymer of one or more monomers selected from (meth)acrylic acid and a (meth)acrylic acid ester. The (meth)acrylic acid ester is not particularly limited, and is preferably an alkyl ester having 1 to 12 carbon atoms of (meth)acrylic acid.

The styrene-(meth)acrylic resin is a copolymer of styrene and at least one monomer selected from (meth)acrylic acid and a (meth)acrylic acid ester.

A content of the binder in the clay coat layer is preferably 2 mass% or more, more preferably 10 mass% or more, and even more preferably 15 mass% or more, and is preferably 50 mass% or less, more preferably 40 mass% or less, and even more preferably 30 mass% or less.

A coating amount of the clay coat layer is not particularly limited, and is preferably 5 g/m$^2$ or more, and more preferably 7 g/m$^2$ or more, and is preferably 30 g/m$^2$ or less, and more preferably 20 g/m$^2$ or less, in terms of solid content.

A method for forming the clay coat layer is not particularly limited, and is preferably a method in which a dispersion liquid containing an inorganic pigment and a resin binder is applied onto a paper substrate and dried to form the clay coat layer. The dispersion liquid containing an inorganic pigment and a resin binder is preferably a dispersion liquid containing an aqueous medium such as an aqueous dispersion liquid as a solvent. That is, the clay coat layer is preferably formed using an aqueous medium. In the present description, the term "aqueous medium" means a medium containing 50 mass% or more of water. Examples of the coating method include a bar coating method, a blade coating method, a squeeze coating method, an air knife coating method, a roll coating method, a gravure coating method, and a transfer coating method. A coating machine such as a fountain coater or a slit die coater may be used.

<Resin Layer>

The base paper for vapor deposition paper according to the present embodiment includes the resin layer disposed on the clay coat layer. By forming the resin layer, an adhesion between the vapor deposition layer and the paper substrate in the vapor deposition paper can be improved, and the barrier properties can be improved. The oxygen barrier property or the water vapor barrier property of the resin layer also functions to improve the barrier properties in the case of forming the vapor deposition paper.

The resin layer preferably contains a resin having a glass transition temperature of 50°C or higher. By forming the resin layer using the resin having a glass transition temperature of 50°C or higher, smoothness of the surface of the resin layer can be maintained even when exposed to a high-temperature vapor during vapor deposition, and a vapor deposition layer with few defects can be formed on the resin layer. Accordingly, it is considered that the obtained vapor deposition paper can exhibit excellent barrier properties. An upper limit of the glass transition temperature of the resin is not particularly limited, and is, for example, 200°C or lower. When the resin contained in the resin layer is a polyester-based resin and a polyurethane-based resin as described below, the glass transition temperature is preferably 150°C or lower, more preferably 140°C or lower, and even more preferably 135°C or lower. The glass transition temperature of the resin contained in the resin layer can be confirmed by a method described in Examples. That is, a part of the resin layer of the base paper for vapor deposition is scraped off, and the glass transition temperature is measured in conformity with JIS K 7121:1987. When the glass transition temperature is 50°C or higher, it can be said that the resin layer contains a resin having a glass transition temperature of 50°C or higher. In other words, the glass transition temperature of the resin layer is preferably 50°C or higher as measured in conformity with JIS K 7121:1987, and an upper limit thereof is not particularly limited, and is, for example, 200°C or lower.

The resin layer preferably contains a water-suspendable polymer, that is, is formed of a coating liquid containing a water-suspendable polymer, and more preferably mainly contains a water-suspendable polymer. The expression "the resin layer mainly contains a water-suspendable polymer" means that a content of the water-suspendable polymer in the resin layer is, for example, 50 mass% or more, preferably 60 mass% or more, more preferably 70 mass% or more, even more preferably 80 mass% or more, still more preferably 90 mass% or more, and particularly preferably 95 mass% or more. An upper limit thereof is not particularly limited, and is 100 mass% or less. The resin layer may further contain an optional component in addition to the water-suspendable polymer. In the present description, the term "water-suspendable" means that solubility in water at 25°C is 10 g/L or less.

(Water-suspendable Polymer)

The water-suspendable polymer contained in the resin layer is not particularly limited, and examples thereof include: an alkyd resin; a (meth)acrylic (co)polymer and a styrene-(meth)acrylic resin; an olefin-unsaturated carboxylic acid-based copolymer such as an ethylene-acrylic acid copolymer and an ethylene-methacrylic acid copolymer; a vinyl alcohol-based resin such as a polyvinyl alcohol and an ethylene-vinyl alcohol copolymer (ethylene-modified polyvinyl alcohol); a cellulose-based resin; a polyurethane-based resin; and a polyester-based resin. Among them, preferred are one or more selected from a vinyl alcohol-based resin, a polyurethane-based resin, and a polyester-based resin, more preferred are one or more selected from the group consisting of a polyester-based resin and a polyurethane-based resin from the viewpoint of further improving a biodegradation degree and recyclability, even more preferred are a polylactic acid resin and a polyurethane-based resin, and particularly preferred is a polyurethane-based resin from the viewpoint of further improving the gas barrier property.

<<Polyester-based Resin>>

The polyester-based resin contained in the resin layer is not particularly limited. For example, it is more preferred that the polyester-based resin can be prepared into one or more selected from the group consisting of a polyester-based resin dispersion and emulsion, it is even more preferred that the polyester-based resin can be prepared into a polyester-based resin dispersion or emulsion, and it is still more preferred that the polyester-based resin can be prepared into a polyester-based resin dispersion.

Examples of the polyester-based resin include polylactic acid.

The polyester-based resin contained in the resin layer preferably contains polylactic acid. Since polylactic acid is biodegradable and has high affinity for water due to being a polyester, the recyclability of paper when used in the resin layer is high.

As the polyester-based resin, a commercially available product may be used, and examples thereof include "ELITEL KT series (trade name)" manufactured by Unitika Ltd. and "LANDY PL series (trade name)" manufactured by Miyoshi Oil & Fat Co., Ltd. Specific examples thereof include ELITEL KT-8803 and LANDY PL-3000.

<<Polyurethane-based Resin>>

The polyurethane-based resin contained in the resin layer is not particularly limited. For example, it is more preferred that the polyurethane-based resin can be prepared into one or more selected from the group consisting of a polyurethane-based resin dispersion and emulsion, it is even more preferred that the polyurethane-based resin can be prepared into a polyurethane-based resin dispersion or emulsion, and it is still more preferred that the polyurethane-based resin can be prepared into a polyurethane-based resin dispersion.

The polyurethane-based resin contained in the resin layer preferably contains at least one selected from the group consisting of a structural unit derived from meta-xylylene diisocyanate and a structural unit derived from hydrogenated meta-xylylene diisocyanate. When the polyurethane-based resin contains at least one of the structural unit derived from meta-xylylene diisocyanate and the structural unit derived from hydrogenated meta-xylylene diisocyanate, a total content of the structural unit derived from meta-xylylene diisocyanate and the structural unit derived from hydrogenated meta-xylylene diisocyanate is preferably 50 mol% or more with respect to a total amount of structural units derived from a polyisocyanate. Such a polyurethane-based resin exhibits a high cohesive force due to a hydrogen bond and a stacking effect between xylylene groups, and thus has an excellent gas barrier property. The content can be identified by using a known analysis method such as $^1$H-NMR.

-Oxygen Permeability-

An oxygen permeability of the polyurethane-based resin contained in the resin layer is preferably 100 mL/(m$^2$·day·atm) or less, more preferably 50 mL/(m$^2$·day·atm) or less, even more preferably 25 mL/(m$^2$·day·atm) or less, and still more preferably 10 mL/(m$^2$·day·atm) or less at 23°C and 50% RH when the polyurethane-based resin is molded into a sheet having a thickness of 25 pm. In the present description, the oxygen permeability is measured using an oxygen permeability measuring device (OX-TRAN2/22, manufactured by MOCON Corporation) under conditions of 23°C and 50% RH.

As the polyurethane-based resin, a synthetic product may be used, and examples thereof include a polyurethane-based resin described in WO 2015/016069. As the polyurethane-based resin, a commercially available product may be used, and examples thereof include "TAKELAC W (trade name)", "TAKELAC WPB (trade name)", and "TAKELAC WS (trade name)" manufactured by Mitsui Chemicals, Inc. Specific examples thereof include TAKELAC WPB-341. Examples of other commercially available products thereof include "HPU W-003" (hydroxyl value: 235 mgKOH/g) manufactured by Dainichiseika Color & Chemicals Manufacturing Co., Ltd.

(Silane Coupling Agent)

From the viewpoint of improving bending resistance of the resin layer, the resin layer preferably contains a silane coupling agent in addition to the water-suspendable polymer.

The silane coupling agent is a compound having at least one alkoxysilyl group and at least one reactive functional group other than the alkoxysilyl group in one molecule. The alkoxysilyl group may be a mono alkoxy silyl group, a dialkoxysilyl group, or a trialkoxysilyl group. A trialkoxysilyl group is preferred from the viewpoint of reactivity.

Examples of the reactive functional group other than the alkoxysilyl group include a vinyl group, an epoxy group, a styryl group, a (meth)acryloyloxy group, an amino group, an isocyanato group, a ureido group, and an acid anhydride group. Among them, an amino group, an epoxy group, and an acid anhydride group are preferred, and an amino group is more preferred.

Examples of an epoxy group-containing silane coupling agent include 3-glycidoxypropyltrimethoxysilane, 3-glycidoxypropyltriethoxysilane, 3-glycidoxypropylmethyldiethoxysilane, and 2-(3,4-epoxycyclohexyl)ethyltrimethoxysilane.

Examples of an amino group-containing silane coupling agent include 3-aminopropyltrimethoxysilane, 3-aminopropyltriethoxysilane, N-2-(aminoethyl)-3-aminopropylmethyldimethoxysilane, N-2-(aminoethyl)-3-aminopropyltrimethoxysilane, 3-triethoxysilyl-N-(1,3-dimethylbutylidene)propylamine, and N-phenyl-3-aminopropyltrimethoxysilane. Among them, 3-aminopropyltriethoxysilane is preferred.

Examples of an acid anhydride group-containing silane coupling agent include 3-trimethoxysilylpropyl succinic anhydride.

As the silane coupling agent, a commercially available product may be used, and examples thereof include KBM-303, KBM-402, KBM-403, KBE-402, KBE-403, KBM-602, KBM-603, KBM-903, KBE-903, KBE-9103P, KBM-573, and X-12-967C manufactured by Shin-Etsu Chemical Co., Ltd.

A blending amount of the silane coupling agent is preferably 0.03 parts by mass or more, more preferably 0.1 parts by mass or more, even more preferably 0.2 parts by mass or more, and particularly preferably 0.3 parts by mass or more, and is also preferably 10 parts by mass or less, more preferably 8 parts by mass or less, even more preferably 6 parts by mass or less, and particularly preferably 5 parts by mass or less, with respect to 100 parts by mass of the water-suspendable polymer.

A coating amount of the resin layer is not particularly limited, and is more preferably 0.1 $g/m^2$ or more, and more preferably 1 $g/m^2$ or more, and is preferably 10 $g/m^2$ or less, and more preferably 5 $g/m^2$ or less, in terms of solid content. A method for forming the resin layer is not particularly limited, and it is preferred to form the resin layer by applying and drying an aqueous medium such as an aqueous solution or an aqueous dispersion liquid of the water-suspendable polymer. That is, the resin layer is preferably formed using an aqueous medium. Examples of the coating method include a bar coating method, a blade coating method, a squeeze coating method, an air knife coating method, a roll coating method, a gravure coating method, and a transfer coating method. A coating machine such as a fountain coater or a slit die coater may be used.

<Physical Properties of Base Paper for Vapor Deposition Paper>

(Wetting Tension)

In the base paper for vapor deposition paper according to the present embodiment, the wetting tension of the surface of the resin layer is 50 mN/m or more, and preferably 55 mN/m or more as measured in conformity with JIS K 6768:1999. When the wetting tension of the surface of the resin layer is within the above range, a polarity of the surface of the resin layer is increased, and an adhesion between the resin layer and the vapor deposition layer formed on the resin layer is improved. Accordingly, it is considered that the obtained vapor deposition paper can exhibit excellent barrier properties. An upper limit of the wetting tension of the surface of the resin layer is not particularly limited, and is, for example, 70 mN/m or less. For example, the wetting tension can be adjusted within the above range by adjusting a component used in the resin layer (for example, selecting the type of the water-suspendable polymer used in the resin layer). The wetting tension of the surface of the resin layer is measured at 23°C.

(Print-surf Surface Roughness)

In the base paper for vapor deposition paper according to the present embodiment, the print-surf surface roughness of the surface of the resin layer is 2.5 pm or less, preferably 1.5 pm or less, more preferably 1.2 pm or less, and even more preferably 1.0 pm or less as measured in conformity with JIS P 8151:2004. When the print-surf surface roughness of the surface of the resin layer is within the above range, a vapor deposition layer with few defects can be formed on the resin layer. Accordingly, it is considered that the obtained vapor deposition paper can exhibit excellent barrier properties. A lower limit of the print-surf surface roughness of the surface of the resin layer is not particularly limited, and is, for example, 0.1 pm or more, 0.3 pm or more, or 0.5 pm or more. For example, the print-surf surface roughness can be adjusted within the above range by adjusting a treatment with a calendar on the paper substrate, a coating method for the clay coat layer and the resin layer (for example, a blade coating method), and a coating amount of the resin layer, or the like.

(Cobb Water Absorption)

In the base paper for vapor deposition paper according to the present embodiment, a Cobb water absorption of the surface of a coating layer (the resin layer) is preferably 0 $g/m^2$ or more, and preferably 10 $g/m^2$ or less, and more preferably 5 $g/m^2$ or less at a temperature of 23°C and a contact time of 120 seconds, as measured in conformity with JIS P 8140:1998. It is preferred that the Cobb water absorption of the base paper for vapor deposition paper is within the above range since a decrease in a vacuum degree due to the influence of moisture during vapor deposition can be prevented, and in addition, a film which does not allow water to pass therethrough and has few defects can be formed, so that a vapor deposition layer can be formed with a high vacuum degree, and a vapor deposition layer with few defects can be obtained. Accordingly, it is considered that the obtained vapor deposition paper can exhibit excellent barrier properties. The Cobb water absorption can be adjusted within the above range by adjusting a coating amount of the coating layer (for example, a resin layer) or selecting a component of the coating layer (for example, a resin for a resin layer).

(Contact Angle)

In the base paper for vapor deposition paper according to the present embodiment, a contact angle of the surface of the coating layer (the resin layer) to water after 60 seconds is preferably 65° or less, and more preferably 60° or less as measured in conformity with JIS R 3257:1999. It is preferred that the contact angle of the surface of the coating layer of the base paper for vapor deposition paper is within the above range since a polarity of the surface of the coating layer is increased and an adhesion between the coating layer and a vapor deposition layer formed on the coating layer is improved. Accordingly, it is considered that the obtained vapor deposition paper can exhibit excellent barrier properties. A lower limit of the contact angle of the surface of the coating layer to water after 60 seconds is not particularly limited, and is, for example, 10° or more, 30° or more, or 50° or more. The contact angle can be adjusted within the above range by adjusting the coating amount of the coating layer (for example, a resin layer) or selecting a component of the coating layer (for example, a resin for a resin layer). The contact angle of the surface of the coating layer is measured at 23°C.

(Surface Specific Electric Resistance)

In the base paper for vapor deposition paper according to the present embodiment, a surface specific electric resistance of the surface of the coating layer (the resin layer) is preferably $0.1 \times 10^{14}$ Ω or more, and more preferably $1 \times 10^{14}$ Ω or more, and is preferably $10 \times 10^{14}$ Ω or less, and more preferably $5 \times 10^{14}$ Ω or less, as measured in conformity with JIS C 2139:2008. When the surface specific electric resistance of the surface of the coating layer of the base paper for vapor deposition paper is within the above range, continuity of the resin film on the surface of the coating layer is improved, and the film-forming property of the vapor deposition layer formed on the resin layer is improved. Accordingly, it is considered that the obtained vapor deposition paper can exhibit excellent barrier properties. The surface specific electric resistance can be adjusted within the above range by adjusting the coating amount of the coating layer (for example, a resin layer) or selecting the component of the coating layer (for example, a resin for a resin layer).

(Biodegradation Degree)

In the base paper for vapor deposition paper according to the present embodiment, a biodegradation degree is preferably 85% or more, and more preferably 90% or more (upper limit value: 100%), as measured in conformity with JIS K 6955:2017. The vapor deposition paper obtained using the base paper for vapor deposition paper that satisfies the above biodegradation degree has excellent recyclability. The biodegradation degree is preferably within the above range within 2 years, more preferably within the above range within 1 year, and even more preferably within the above range within 6 months. The biodegradation degree of the base paper for vapor deposition paper can be adjusted within the above range by adjusting a blending amount of a biodegradable material (for example, a biodegradable resin) in the base paper. Specifically, preferably 90 mass% or more, and more preferably 95 mass% or more of the component in the base paper for vapor deposition paper, excluding an inorganic material, is the biodegradable material (upper limit value: 100 mass%).

It is preferred that the biodegradation degree of the base paper for vapor deposition paper according to the present embodiment is equal to or more than a specific value since vapor deposition paper having excellent recyclability, a high oxygen barrier property, and a high water vapor barrier property can be obtained.

(Thickness)

A thickness of the base paper for vapor deposition paper according to the present embodiment is preferably 10 pm or more, and more preferably 30 pm or more, and is preferably 100 pm or less, and more preferably 80 pm or less.

Amethod for producing the base paper for vapor deposition paper according to the present embodiment is not limited. For example, as a method for producing the base paper for vapor deposition paper that includes a paper substrate, and a clay coat layer and a resin layer in this order on at least one surface of the paper substrate, it is preferred to form the base paper by applying and drying a clay coat layer coating liquid containing an inorganic pigment and a binder, and then applying and drying a resin layer coating liquid containing a water-suspendable polymer.

[Vapor Deposition Paper]

Another embodiment of the present invention is vapor deposition paper including: the base paper for vapor deposition paper; and a vapor deposition layer, an overcoat layer, and, if necessary, a heat seal layer in this order on the resin layer of the base paper for vapor deposition paper. That is, the present invention also provides the use of the base paper for vapor deposition paper in the production of vapor deposition paper, and a method for producing vapor deposition paper using the base paper for vapor deposition paper.

<Vapor Deposition Layer>

The vapor deposition layer is at least one of a layer made of a metal and a layer made of ceramic. That is, the vapor deposition layer may be any of a layer made of a metal, a layer made of ceramic, and a laminate of a metal layer and a ceramic layer. When the vapor deposition layer is a laminate of a metal layer and a ceramic layer, the metal layer may be on a resin layer side of the base paper for vapor deposition paper, or the ceramic layer may be on the resin layer side of the base paper for vapor deposition paper, with no particular limitations.

The vapor deposition layer may be any of a layer made of a metal, a layer made of ceramic, and a laminate thereof, and is preferably a layer made of a metal. When the vapor deposition layer is a layer made of a metal, specific examples of the metal include aluminum and titanium. These may be used alone or may be used in combination with two or more kinds thereof. Among them, aluminum is preferred. When the vapor deposition layer is a layer made of ceramic, specific examples of the ceramic include silicon oxide, titanium oxide, and aluminum oxide. These may be used alone or may be used in combination with two or more kinds thereof. Among them, silicon oxide and aluminum oxide are preferred.

That is, the vapor deposition layer is more preferably any of a layer made of aluminum, a layer made of silicon oxide, a layer made of titanium oxide, a layer made of aluminum oxide, and a laminate thereof, even more preferably any of a layer made of aluminum, a layer made of silicon oxide, a layer made of aluminum oxide, and a laminate thereof, and particularly preferably a layer made of aluminum.

(Thickness)

A thickness of the vapor deposition layer is preferably 1 nm or more, more preferably 2 nm or more, and even more preferably 3 nm or more, and is preferably 1000 nm or less, more preferably 500 nm or less, and even more preferably 100 nm or less. From the viewpoint of barrier properties, the thickness of the vapor deposition layer is preferably 10 nm or more, and more preferably 25 nm or more, and is preferably 80 nm or less, and more preferably 70 nm. From the viewpoint of adhesion to other layers and cost, the thickness of the vapor deposition layer is preferably 4 nm or more, and more preferably 5 nm or more, and is preferably 100 nm or less, more preferably 70 nm or less, and particularly preferably 60 nm or less.

<Overcoat Layer>

The vapor deposition paper according to the present embodiment preferably includes an overcoat layer containing a polyurethane-based resin on the vapor deposition layer. The vapor deposition paper according to the present embodiment has certain barrier properties due to the vapor deposition layer, and the oxygen barrier property can be further improved by forming the overcoat layer containing a polyurethane-based resin on the vapor deposition layer. The vapor deposition layer is less likely to be damaged by processing such as bending, and even when the vapor deposition layer is damaged, the oxygen barrier property can be secured by the overcoat layer, and an excellent oxygen barrier property can be maintained.

Examples of the polyurethane-based resin as a binder contained in the overcoat layer include those exemplified as the polyurethane-based resin of the resin layer. For example, it is more preferred that the polyurethane-based resin can be prepared into one or more selected from the group consisting of a polyurethane-based resin dispersion and emulsion, it is even more preferred that the polyurethane-based resin can be prepared into a polyurethane-based resin dispersion or emulsion, and it is still more preferred that the polyurethane-based resin can be prepared into a polyurethane-based resin dispersion.

The polyurethane-based resin contained in the overcoat layer preferably contains at least one selected from the group consisting of a structural unit derived from meta-xylylene diisocyanate and a structural unit derived from hydrogenated meta-xylylene diisocyanate. When the polyurethane-based resin contains at least one of the structural unit derived from meta-xylylene diisocyanate and the structural unit derived from hydrogenated meta-xylylene diisocyanate, a total content of the structural unit derived from meta-xylylene diisocyanate and the structural unit derived from hydrogenated meta-xylylene diisocyanate is preferably 50 mol% or more with respect to a total amount of structural units derived from a polyisocyanate. Such a polyurethane-based resin exhibits a high cohesive force due to a hydrogen bond and a stacking effect between xylylene groups, and thus has an excellent gas barrier property.

The polyurethane-based resin contained in the overcoat layer may have a hydroxy group, and a hydroxyl value thereof is preferably 50 mgKOH/g or more, more preferably 100 mgKOH/g or more, and even more preferably 150 mgKOH/g or more. An upper limit thereof is not particularly limited, and is preferably 1000 mgKOH/g or less, more preferably 800 mgKOH/g or less, and even more preferably 600 mgKOH/g or less. It is preferred that the hydroxyl value of the polyurethane-based resin is within the above range since the oxygen barrier property is excellent.

(Oxygen Permeability)

An oxygen permeability of the polyurethane-based resin contained in the overcoat layer is preferably 100 mL/(m$^2$·day·atm) or less, more preferably 50 mL/(m$^2$·day·atm) or less, even more preferably 25 mL/(m$^2$·day·atm) or less, and still more preferably 10 mL/(m$^2$·day·atm) or less at 23°C and 50% RH when the polyurethane-based resin is molded into a sheet having a thickness of 25 pm.

The polyurethane-based resin as the binder contained in the overcoat layer may be the same as or different from the polyurethane-based resin contained in the resin layer of the base paper for vapor deposition paper, and is preferably the same as the polyurethane-based resin contained in the resin layer of the base paper for vapor deposition paper. As the resin layer of the base paper for vapor deposition paper, a synthetic product or a commercially available product exemplified as usable ones may be used.

A content of the polyurethane-based resin in the overcoat layer is preferably 80 mass% or more, more preferably 90 mass% or more, even more preferably 95 mass% or more, and still more preferably 99 mass% or more. An upper limit thereof is not particularly limited, and is 100 mass% or less.

The overcoat layer may contain other resins and additives as long as the effects of the present invention are not impaired. Examples of the additive include a surfactant, a pigment, an antioxidant, an antistatic agent, a dye, a plasticizer, a lubricant, and a release agent. When the polyurethane-based resin is used as an aqueous dispersion liquid, it is preferred to use a dispersant in order to disperse the polyurethane-based resin in an aqueous medium to obtain a uniform overcoat layer film.

A coating amount of the overcoat layer is preferably 0.1 g/m$^2$ or more, more preferably 0.2 g/m$^2$ or more, and particularly preferably 0.3 g/m$^2$ or more, and is preferably 10 g/m$^2$ or less, more preferably 7 g/m$^2$ or less, and particularly preferably 4 g/m$^2$ or less, in terms of solid content.

A thickness of the overcoat layer is preferably 0.1 pm or more, more preferably 0.2 pm or more, and particularly preferably 0.3 pm or more, and is preferably 10 pm or less, more preferably 7 pm or less, and particularly preferably 4 pm or less. When the thickness of the overcoat layer is 0.1 pm or more and 10 pm or less, the protective property for the vapor deposition layer is improved, and the paper is excellent in disintegrability during recycling, and is also excellent in recyclability.

A method for forming the overcoat layer is not particularly limited, and it is preferred to form the overcoat layer by applying and drying an aqueous medium such as an aqueous solution or an aqueous dispersion liquid of the polyurethane-based resin.

In the vapor deposition paper according to the present embodiment, the overcoat layer may be an outermost layer. Even when the overcoat layer is the outermost layer, the design of the vapor deposition layer having a glossiness is not impaired. In the case of forming vapor deposition layers on both surfaces, the overcoat layer may be formed on one surface or both surfaces. Among them, it is preferred to form the overcoat layer on one surface. When the overcoat layer is formed on one surface, the production efficiency is excellent.

[Method for Producing Vapor Deposition Paper]

A method for producing the vapor deposition paper according to the present embodiment is not limited, and it is preferred to include a step of forming a vapor deposition layer by vapor-depositing at least one of a metal and ceramic on a surface of the base paper for vapor deposition paper where the resin layer is formed, the base paper for vapor deposition paper including a paper substrate, and a clay coat layer and the resin layer in this order on at least one surface of the paper substrate, and a step of forming an overcoat layer by applying and drying an overcoat layer coating liquid on the vapor deposition layer.

As a method of vapor-depositing a metal or ceramic, a method of vacuum-depositing a metal or ceramic directly on the surface of the resin layer of the base paper for vapor deposition paper is preferred.

The overcoat layer is preferably formed directly on the vapor deposition layer from the viewpoint of efficiently protecting the vapor deposition layer and enhancing barrier properties. As the method for forming the overcoat layer, the overcoat layer is preferably obtained by applying and drying an overcoat layer liquid. By using the method of forming the overcoat layer by applying an overcoat layer coating liquid, an overcoat layer having a relatively small thickness of 10 pm or less can be formed. By forming such a relatively thin overcoat layer, excellent disintegrability can be imparted, and vapor deposition paper having excellent recyclability can be obtained.

Examples of the overcoat layer coating liquid used herein include a solution using an organic solvent that dissolves a polyurethane-based resin, a dispersion liquid using an organic solvent that disperses a polyurethane-based resin, and a dispersion liquid using an aqueous medium. A dispersion liquid using an aqueous medium is preferred from the viewpoint of coatability and an environmental load.

Examples of the method for applying an overcoat layer coating liquid include a bar coating method, a blade coating method, a squeeze coating method, an air knife coating method, a roll coating method, a gravure coating method, and a transfer coating method. A coating machine such as a fountain coater or a slit die coater may be used.

The coated vapor deposition paper coated with the overcoat layer coating liquid is dried to remove the organic solvent or the aqueous medium, thereby obtaining vapor deposition paper including an overcoat layer on the vapor deposition layer.

<Heat Seal Layer>

Further, a heat seal layer containing a thermoplastic resin may be formed on the overcoat layer. Examples of the method for forming the heat seal layer include a method of applying and drying a thermoplastic resin solution or a thermoplastic resin dispersion liquid, and an extrusion lamination method. Among them, it is preferred to apply and dry a thermoplastic resin solution or a thermoplastic resin dispersion liquid.

Examples of the thermoplastic resin solution or the thermoplastic resin dispersion liquid used herein include a solution using an organic solvent that dissolves a thermoplastic resin, a dispersion liquid using an organic solvent that disperses a thermoplastic resin, and a dispersion liquid using an aqueous medium. A dispersion liquid using an aqueous medium is preferred from the viewpoint of coatability and an environmental load.

The thermoplastic resin suitable for the dispersion liquid using an aqueous medium may be any of a natural resin and a synthetic resin, and examples thereof include a starch derivative, casein, shellac, a polyvinyl alcohol and a derivative thereof, an acrylic resin, an ionomer-based resin, a maleic acid-based resin, a urethane-based resin, a polyester-based resin, a styrene-butadiene-based resin, a vinyl chloride-based resin, and a polyolefin-based resin.

More specifically, examples of the acrylic resin include an acrylic resin obtained by copolymerizing, as a monomer component, (meth)acrylic acid and an alkyl ester thereof or styrene, a styrene-maleic acid resin, a styrene-acrylic acid-maleic acid resin, a water-soluble polyurethane resin, and a water-soluble polyester resin.

Preferred examples of the ionomer-based resin include an ethylene-acrylic acid copolymer ionomer and an ethylene-methacrylic acid ionomer. Here, an ionomer is a polymer neutralized with a cation, and examples of the cation include a metal ion, an ammonium ion ($NH_4^+$), and an organic ammonium ion. Examples of the metal ion include an alkali metal ion such as a lithium ion ($Li^+$), a sodium ion ($Na^+$), and a potassium ion ($K^+$), an alkaline earth metal ion such as a magnesium ion ($Mg^{2+}$) and a calcium ion ($Ca^{2+}$), and a transition metal ion such as a zinc ion ($Zn^{2+}$) and a copper ion ($Cu^{2+}$). Among them, a sodium ion is preferred as the metal ion from the viewpoint of availability and the like.

Among them, from the viewpoint of stability of the coating liquid and solvent resistance of the heat seal layer, preferred is at least one selected from a starch derivative, casein, shellac, a polyvinyl alcohol and a derivative thereof, an ionomer-based resin, an acrylic resin, and a maleic acid-based resin, more preferred is at least one selected from a starch derivative, a polyvinyl alcohol, a polyvinyl alcohol derivative, an ionomer-based resin, an acrylic resin, and a maleic acid-based resins, even more preferred is at least one selected from a starch derivative, a polyvinyl alcohol, a polyvinyl alcohol derivative, an ionomer-based resin, and an acrylic resin, and still more preferred is at least one selected from a polyvinyl alcohol, a polyvinyl alcohol derivative, and an ionomer-based resin.

Examples of the method for applying the thermoplastic resin solution or the thermoplastic resin dispersion liquid include a bar coating method, a blade coating method, a squeeze coating method, an air knife coating method, a roll coating method, a gravure coating method, and a transfer coating method. A coating machine such as a fountain coater or a slit die coater may be used.

After the thermoplastic resin solution or the thermoplastic resin dispersion liquid is applied onto the overcoat layer, drying is performed to remove the organic solvent or the aqueous medium, thereby obtaining vapor deposition paper including a heat seal layer on the overcoat layer.

A thickness of the heat seal layer is not particularly limited, and is preferably 1 pm or more and less than 15 pm. When the thickness of the heat seal layer is 1 pm or more, sufficient heat sealability can be secured. When the thickness of the heat seal layer is less than 15 pm, disintegrability can be imparted, and vapor deposition paper having excellent recyclability can be obtained.

<Physical Properties of Vapor Deposition Paper>

(Thickness)

A thickness of the vapor deposition paper according to the present embodiment is preferably 20 pm or more, and more preferably 50 pm or more, and is preferably 200 pm or less, and more preferably 150 pm or less. The thickness of the vapor deposition paper is measured in conformity with JIS P 8118:2014.

(Oxygen Permeability)

An oxygen permeability of the vapor deposition paper according to the present embodiment is preferably 1.0 mL/(m$^2$·day·atm) or less, and more preferably 0.5 mL/(m$^2$·day·atm) or less (lower limit: 0 mL/(m$^2$·day·atm)) at 23°C and 50% RH. The oxygen permeability of the vapor deposition paper is measured by a method described in Examples.

(Water Vapor Permeability)

A water vapor permeability of the vapor deposition paper according to the present embodiment is preferably 1.0 g/(m$^2$·day) or less, and more preferably 0.7 g/(m$^2$·day) or less (lower limit: 0 g/(m$^2$·day)) at 40°C and 90% RH. The water vapor permeability of the vapor deposition paper is measured by a method described in Examples.

(Heat Seal Peel Strength)

A maximum load heat seal peel strength of the vapor deposition paper according to the present embodiment is preferably 2 N/15 mm or more when heat seal layers are heat-sealed to each other under conditions of 160°C, 0.2 MPa, and 1 second and a test piece having a width of 15 mm is peeled off in a T-shape manner at a tensile speed of 300 mm/min. Within the above range, suitability as barrier packaging is excellent. A lower limit of the heat seal peel strength is not particularly limited, and is, for example, 20 N/15 mm or less.

(Pulp Recovery Rate after Re-disintegration)

A pulp recovery rate of the vapor deposition paper according to the present embodiment after re-disintegration is preferably 75% or more, more preferably 80% or more, even more preferably 82% or more, and still more preferably 85% or more. The pulp recovery rate of the vapor deposition paper after re-disintegration is measured by a method described in Examples.

The vapor deposition paper according to the present embodiment can be suitably used as a packaging material for food such as coffee, confectionery, and milk, a drug medicine, a medical product, an electronic part, and the like by taking advantage of the above-described excellent barrier properties, and is also excellent in recyclability.

The present invention further discloses the following <1> to <49>.

<1> Base paper for vapor deposition paper, the base paper including:

a paper substrate; and
a clay coat layer and a resin layer in this order on at least one surface of the paper substrate, in which
a surface of the resin layer has a wetting tension of 50 mN/m or more as measured in conformity with JIS K 6768:1999 and a print-surf surface roughness of 2.5 pm or less as measured in conformity with JIS P 8151:2004.

<2> The base paper for vapor deposition paper according to <1>, in which
the resin layer contains a resin having a glass transition temperature of 50°C or higher.
<3> The base paper for vapor deposition paper according to <1> or <2>, in which
the resin layer contains a water-suspendable polymer.
<4> The base paper for vapor deposition paper according to any one of <1> to <3>, in which

the water-suspendable polymer contained in the resin layer is one or more selected from the group consisting of a polyester-based resin and a polyurethane-based resin.

<5> The base paper for vapor deposition paper according to <4>, in which

the polyurethane-based resin has an oxygen permeability of 100 mL/(m$^2$·day·atm) or less at 23°C and 50% RH when molded into a sheet having a thickness of 25 pm.

<6> The base paper for vapor deposition paper according to <4> or <5>, in which

the polyurethane-based resin contains at least one selected from the group consisting of a structural unit derived from meta-xylylene diisocyanate and a structural unit derived from hydrogenated meta-xylylene diisocyanate.

<7> The base paper for vapor deposition paper according to any one of <4> to <6>, in which

a total content of the structural unit derived from meta-xylylene diisocyanate and the structural unit derived from hydrogenated meta-xylylene diisocyanate in the polyurethane-based resin is 50 mol% or more with respect to a total amount of structural units derived from a polyisocyanate.

<8> The base paper for vapor deposition paper according to any one of <1> to <7>, in which

the clay coat layer contains an inorganic pigment and a binder, and the inorganic pigment has an aspect ratio of 50 or less and an average particle diameter of 5 pm or less.

<9> The base paper for vapor deposition paper according to <8>, in which

the inorganic pigment is kaolin.

<10> The base paper for vapor deposition paper according to <8> or <9>, in which

the binder contained in the clay coat layer is one or more selected from the group consisting of a styrene-butadiene-based resin, a styrene-(meth)acrylic resin, an olefin-unsaturated carboxylic acid-based copolymer, and polylactic acid.

<11> The base paper for vapor deposition paper according to any one of <1> to <10>, in which

the clay coat layer and the resin layer are formed using an aqueous medium.

<12> Vapor deposition paper including:

the base paper for vapor deposition paper according to any one of <1> to <11>; and
a vapor deposition layer on the resin layer of the base paper for vapor deposition paper.

<13> The vapor deposition paper according to <12>, further including:

an overcoat layer containing a polyurethane-based resin on the vapor deposition layer, in which
the polyurethane-based resin contained in the overcoat layer contains at least one selected from the group consisting of a structural unit derived from meta-xylylene diisocyanate and a structural unit derived from hydrogenated meta-xylylene diisocyanate.

<14> The vapor deposition paper according to <13>, further including:

a heat seal layer containing a thermoplastic resin on the overcoat layer, in which
a maximum load heat seal peel strength is 2 N/15 mm or more when heat seal layers are heat-sealed to each other under conditions of 160°C, 0.2 MPa, and 1 second and a test piece having a width of 15 mm is peeled off in a T-shape manner at a tensile speed of 300 mm/min.

<15> The vapor deposition paper according to any one of <12> to <14>, in which

an oxygen permeability is 1.0 mL/(m$^2$·day·atm) or less at 23°C and 50% RH, and a water vapor permeability is 1.0 g/(m$^2$·day) or less at 40°C and 90% RH.

<16> Base paper for vapor deposition paper, the base paper including:

a paper substrate; and
a coating layer on at least one surface of the paper substrate, in which
the surface of the coating layer has a Cobb water absorption of 0 g/m$^2$ or more and 10 g/m$^2$ or less at a temperature of 23°C and a contact time of 120 seconds, as measured in conformity with JIS P 8140:1998, and
a contact angle of a surface of the coating layer to water after 60 seconds is 65° or less as measured in conformity with JIS R 3257:1999.

<17> The base paper for vapor deposition paper according to <16>, in which

the surface of the coating layer has a surface specific electric resistance of $0.1 \times 10^{14}$ Ω or more and $10 \times 10^{14}$ Ω or less as measured in conformity with JIS C 2139:2008.

<18> The base paper for vapor deposition paper according to <16> or <17>, in which

the coating layer includes a clay coat layer and a resin layer in this order from a paper substrate side.

<19> The base paper for vapor deposition paper according to <18>, in which
the resin layer contains a water-suspendable polymer.

<20> The base paper for vapor deposition paper according to <19>, in which
the water-suspendable polymer contained in the resin layer is one or more selected from the group consisting of a polyester-based resin and a polyurethane-based resin.

<21> The base paper for vapor deposition paper according to <20>, in which
the polyurethane-based resin has an oxygen permeability of 100 mL/(m$^2$·day·atm) or less at 23°C and 50% RH when molded into a sheet having a thickness of 25 pm.

<22> The base paper for vapor deposition paper according to <20> or <21>, in which
the polyurethane-based resin contains at least one selected from the group consisting of a structural unit derived from meta-xylylene diisocyanate and a structural unit derived from hydrogenated meta-xylylene diisocyanate.

<23> The base paper for vapor deposition paper according to any one of <20> to <22>, in which
the polyurethane-based resin has a hydroxy group and a hydroxyl value of 50 mgKOH/g or more.

<24> The base paper for vapor deposition paper according to any one of <20> to <23>, in which
a total content of the structural unit derived from meta-xylylene diisocyanate and the structural unit derived from hydrogenated meta-xylylene diisocyanate in the polyurethane-based resin is 50 mol% or more with respect to a total amount of structural units derived from a polyisocyanate.

<25> The base paper for vapor deposition paper according to any one of <18> to <24>, in which
the clay coat layer contains an inorganic pigment and a binder, and the inorganic pigment has an aspect ratio of 50 or less and an average particle diameter of 5 pm or less.

<26> The base paper for vapor deposition paper according to <25>, in which
the inorganic pigment is kaolin.

<27> The base paper for vapor deposition paper according to <25> or <26>, in which
the binder contained in the clay coat layer is one or more selected from the group consisting of a styrene-butadiene-based resin, a styrene-(meth)acrylic resin, an olefin-unsaturated carboxylic acid-based copolymer, and polylactic acid.

<28> The base paper for vapor deposition paper according to any one of <18> to <27>, in which
the clay coat layer and the resin layer are formed using an aqueous medium.

<29> Vapor deposition paper including:

the base paper for vapor deposition paper according to any one of <16> to <28>; and
a vapor deposition layer on the coating layer of the base paper for vapor deposition paper.

<30> The vapor deposition paper according to <29>, further including:

an overcoat layer containing a polyurethane-based resin on the vapor deposition layer, in which
the polyurethane-based resin contained in the overcoat layer contains at least one selected from the group consisting of a structural unit derived from meta-xylylene diisocyanate and a structural unit derived from hydrogenated meta-xylylene diisocyanate.

<31> The vapor deposition paper according to <30>, in which
the polyurethane-based resin contained in the overcoat layer has a hydroxy group and a hydroxyl value of 50 mgKOH/g or more.

<32> The vapor deposition paper according to <30> or <31>, further including:

a heat seal layer containing a thermoplastic resin on the overcoat layer, in which
a maximum load heat seal peel strength is 2 N/15 mm or more when heat seal layers are heat-sealed to each other under conditions of 160°C, 0.2 MPa, and 1 second and a test piece having a width of 15 mm is peeled off in a T-shape manner at a tensile speed of 300 mm/min.

<33> The vapor deposition paper according to any one of <29> to <32>, in which
an oxygen permeability is 1.0 mL/(m$^2$·day·atm) or less at 23°C and 50% RH, and a water vapor permeability is 1.0 g/(m$^2$·day) or less at 40°C and 90% RH.

<34> Base paper for vapor deposition paper, the base paper including:

a paper substrate; and
a coating layer on at least one surface of the paper substrate, in which

a biodegradation degree is 85% or more as measured in conformity with JIS K 6955:2017.

<35> The base paper for vapor deposition paper according to <34>, in which
90 mass% or more of a component in the base paper for vapor deposition paper, excluding an inorganic material, is a biodegradable material.
<36> The base paper for vapor deposition paper according to <34> or <35>, in which
the coating layer includes a resin layer, and the resin layer contains a water-suspendable polymer.
<37> The base paper for vapor deposition paper according to <36>, in which
the water-suspendable polymer contained in the resin layer is one or more selected from the group consisting of a polyester-based resin and a polyurethane-based resin.
<38> The base paper for vapor deposition paper according to <37>, in which
the polyester-based resin contains polylactic acid.
<39> The base paper for vapor deposition paper according to <37>, in which
the polyurethane-based resin has an oxygen permeability of 100 mL/(m$^2$·day·atm) or less at 23°C and 50% RH when molded into a sheet having a thickness of 25 pm.
<40> The base paper for vapor deposition paper according to <37> or <39>, in which
the polyurethane-based resin contains at least one selected from the group consisting of a structural unit derived from meta-xylylene diisocyanate and a structural unit derived from hydrogenated meta-xylylene diisocyanate.
<41> The base paper for vapor deposition paper according to <37>, <39>, or <40>, in which
a total content of the structural unit derived from meta-xylylene diisocyanate and the structural unit derived from hydrogenated meta-xylylene diisocyanate in the polyurethane-based resin is 50 mol% or more with respect to a total amount of structural units derived from a polyisocyanate.
<42> The base paper for vapor deposition paper according to any one of <34> to <41>, in which
the coating layer includes a clay coat layer, the clay coat layer contains an inorganic pigment and a binder, and the inorganic pigment has an aspect ratio of 50 or less and an average particle diameter of 5 pm or less.
<43> The base paper for vapor deposition paper according to <42>, in which
the inorganic pigment is kaolin.
<44> The base paper for vapor deposition paper according to <42> or <43>, in which
the binder contained in the clay coat layer is one or more selected from the group consisting of a styrene-butadiene-based resin, a styrene-(meth)acrylic resin, an olefin-unsaturated carboxylic acid-based copolymer, and polylactic acid.
<45> The base paper for vapor deposition paper according to any one of <42> to <44>, in which
the clay coat layer and the resin layer are formed using an aqueous medium.
<46> Vapor deposition paper including:

the base paper for vapor deposition paper according to any one of <34> to <45>; and
a vapor deposition layer on the coating layer of the base paper for vapor deposition paper.

<47> The vapor deposition paper according to <46>, further including:

an overcoat layer containing a polyurethane-based resin on the vapor deposition layer, in which
the polyurethane-based resin contained in the overcoat layer contains at least one selected from the group consisting of a structural unit derived from meta-xylylene diisocyanate and a structural unit derived from hydrogenated meta-xylylene diisocyanate.

<48> The vapor deposition paper according to <46> or <47>, in which
a pulp recovery rate after re-disintegration is 80% or more.
<49> The vapor deposition paper according to any one of <46> to <48>, in which
an oxygen permeability is 1.0 mL/(m$^2$·day·atm) or less at 23°C and 50% RH, and a water vapor permeability is 1.0 g/(m$^2$·day) or less at 40°C and 90% RH.

[Examples]

Hereinafter, features of the present invention will be described more specifically with reference to Examples and Comparative Examples. A material, an amount to be used, a proportion, a treatment content, a treatment procedure, and the like described in the following Examples can be appropriately changed without departing from the gist of the present invention. Accordingly, the scope of the present invention should not be construed as being limited to the following specific examples. Unless otherwise specified, "%" and "part" represent "mass%" and "part by mass", respectively.

Unless otherwise specified, operations in Examples and Comparative Examples were performed under conditions of room temperature (20°C to 25°C) and normal humidity (40% RH to 50% RH).

<Example 1-1>

A clay coat layer coating liquid was prepared by mixing 80 parts by mass of kaolin (Contour Xtreme manufactured by IMERYS, aspect ratio: 33, average particle diameter d50: 0.26 pm) and 20 parts by mass (solid content) of a styrene-(meth)acrylic resin (JONCRYL HSL-9012 manufactured by BASF). The clay coat layer coating liquid was applied to a glossy surface of one-side glazed paper (hardwood material ratio: 100%, Stockigt sizing degree: 9 seconds, basis weight: 50 g/m$^2$, thickness: 60 pm, density: 0.83 g/cm$^3$, Oken type smoothness: 430 seconds) with a Mayer bar, and dried at 120°C for 1 minute to form a clay coat layer (12 g/m$^2$, thickness: 4.6 pm). Next, the clay coat layer was coated, by using a Mayer bar, with a resin layer coating liquid prepared by mixing 0.15 parts by mass of 3-aminopropyltriethoxysilane (KBE-903 manufactured by Shin-Etsu Chemical Co., Ltd.) with 100 parts by mass of an aqueous dispersion liquid of a polyurethane-based resin binder having an oxygen permeability (23°C, 50% RH) of 2.0 mL/(m$^2$·day·atm) at a thickness of 25 pm (TAKELAC WPB-341 manufactured by Mitsui Chemicals, Inc., glass transition temperature: 130°C, solid content concentration: 30%), and dried at 120°C for 1 minute to form a resin layer (2 g/m$^2$, thickness: 2 pm), thereby obtaining base paper for vapor deposition paper (thickness: 67 pm).

<Example 1-2>

Base paper for vapor deposition paper was obtained in the same manner as in Example 1-1 except that a coating amount of a resin layer was 1 g/m$^2$ (thickness: 1 pm).

<Example 1-3>

Base paper for vapor deposition paper was obtained in the same manner as in Example 1-1 except that a resin layer (2 g/m$^2$, thickness: 2 pm) was formed using a resin layer coating liquid prepared by mixing 0.15 parts by mass of 3-aminopropyltriethoxysilane (KBE-903 manufactured by Shin-Etsu Chemical Co., Ltd.) with 100 parts by mass of an aqueous dispersion liquid of a polyester-based resin binder (ELITEL KT-8803 manufactured by Unitika Ltd., glass transition temperature: 65°C, solid content concentration: 30%, a saturated copolymerized polyester resin).

<Comparative Example 1-1>

Base paper for vapor deposition paper was obtained in the same manner as in Example 1-1 except that a resin layer (2 g/m$^2$, thickness: 2 pm) was formed using a resin layer coating liquid prepared by mixing 0.145 parts by mass of 3-aminopropyltriethoxysilane (KBE-903 manufactured by Shin-Etsu Chemical Co., Ltd.) with 100 parts by mass of an ethylene-acrylic acid copolymer (ZAIKTHENE AC manufactured by Sumitomo Seika Chemicals Co., Ltd., glass transition temperature: 80°C or lower, solid content concentration: 29 mass%).

<Comparative Example 1-2>

Base paper for vapor deposition paper was obtained in the same manner as in Example 1-1 except that a resin layer (2 g/m$^2$, thickness: 2 pm) was formed using a resin layer coating liquid prepared by mixing 0.20 parts by mass of 3-aminopropyltriethoxysilane (KBE-903 manufactured by Shin-Etsu Chemical Co., Ltd.) with 100 parts by mass of a styrene-(meth)acrylic resin (JONCRYL HSL-9012 manufactured by BASF, glass transition temperature: 5°C or lower, solid content concentration: 40 mass%).

<Comparative Example 1-3>

Base paper for vapor deposition paper was obtained in the same manner as in Example 1-1 except that no resin layer was formed.

<Comparative Example 1-4>

Base paper for vapor deposition paper was obtained in the same manner as in Example 1-3 except that a rough surface of one-side glazed paper was coated.

<Example 2-1>

A clay coat layer coating liquid was prepared by mixing 80 parts by mass of kaolin (Contour Xtreme manufactured by IMERYS, aspect ratio: 33, average particle diameter d50: 0.26 pm) and 20 parts by mass (solid content) of a styrene-(meth)acrylic resin (JONCRYL HSL-9012 manufactured by BASF). The clay coat layer coating liquid was applied to a glossy surface of one-side glazed paper (hardwood material ratio: 100%, basis weight: 50 g/m$^2$, thickness: 60 pm, density: 0.83 g/cm$^3$, Oken type smoothness: 430 seconds, sizing degree: 9 seconds) with a Mayer bar, and dried at 120°C for 1 minute to form a clay coat layer (12 g/m$^2$, thickness: 4.6 pm). Next, the clay coat layer was coated, by using a Mayer bar, with a resin layer coating liquid prepared by mixing 0.15 parts by mass of 3-aminopropyltriethoxysilane (KBE-903 manufactured by Shin-Etsu Chemical Co., Ltd.) with 100 parts by mass of an aqueous dispersion liquid of a polyurethane-based resin binder having an oxygen permeability (23°C, 50% RH) of 2.0 mL/(m$^2$·day·atm) at a thickness of 25 pm (TAKELAC WPB-341 manufactured by Mitsui Chemicals, Inc., glass transition temperature: 130°C, solid content concentration: 30%), and dried at 120°C for 1 minute to form a resin layer (2 g/m$^2$, thickness: 2 pm), thereby obtaining base paper for vapor deposition paper (thickness: 67 pm).

<Example 2-2>

Base paper for vapor deposition paper was obtained in the same manner as in Example 2-1 except that a coating amount of a resin layer was 1 g/m$^2$ (thickness: 1 pm).

<Example 2-3>

Base paper for vapor deposition paper was obtained in the same manner as in Example 2-1 except that a resin layer (2 g/m$^2$, thickness: 2 pm) was formed using a resin layer coating liquid prepared by mixing 0.20 parts by mass of aminopropyltriethoxysilane (KBE-903 manufactured by Shin-Etsu Chemical Co., Ltd.) with 100 parts by mass of a polylactic acid emulsion (LANDY PL-3000 manufactured by Miyoshi Oil & Fat Co., Ltd., solid content concentration: 40%).

<Example 2-4>

Base paper for vapor deposition paper was obtained in the same manner as in Example 2-1 except that a resin layer (2 g/m$^2$, thickness: 2 pm) was formed using a resin layer coating liquid prepared by mixing 0.15 parts by mass of 3-aminopropyltriethoxysilane (KBE-903 manufactured by Shin-Etsu Chemical Co., Ltd.) with 100 parts by mass of an aqueous dispersion liquid of a polyurethane resin binder having a hydroxy group and having an oxygen permeability (23°C, 50% RH) of 1.6 mL/(m$^2$·day·atm) at a thickness of 25 pm (HPU W-003 manufactured by Dainichiseika Color & Chemicals Manufacturing Co., Ltd., hydroxyl value: 235 mgKOH/g, glass transition temperature: 70°C, solid content concentration: 30%).

<Comparative Example 2-1>

Base paper for vapor deposition paper was obtained in the same manner as in Example 2-1 except that a resin layer (2 g/m$^2$, thickness: 2 pm) was formed using a resin layer coating liquid prepared by mixing 0.145 parts by mass of 3-aminopropyltriethoxysilane (KBE-903 manufactured by Shin-Etsu Chemical Co., Ltd.) with 100 parts by mass of an aqueous dispersion liquid of an ethylene-acrylic acid copolymer binder (ZAIKTHENE AC manufactured by Sumitomo Seika Chemicals Co., Ltd., solid content concentration: 29%).

<Comparative Example 2-2>

Base paper for vapor deposition paper was obtained in the same manner as in Example 2-1 except that a resin layer (2 g/m$^2$, thickness: 2 pm) was formed using a resin layer coating liquid prepared by mixing 0.20 parts by mass of 3-aminopropyltriethoxysilane (KBE-903 manufactured by Shin-Etsu Chemical Co., Ltd.) with 100 parts by mass of an aqueous dispersion liquid of a styrene-(meth)acrylic resin (JONCRYL HSL-9012 manufactured by BASF Japan Ltd., solid content concentration: 40%).

<Comparative Example 2-3>

Base paper for vapor deposition paper was obtained in the same manner as in Example 2-1 except that a resin layer (2 g/m$^2$, thickness: 2 pm) was formed using a resin layer coating liquid prepared by mixing 0.05 parts by mass of aminopropyltriethoxysilane (KBE-903 manufactured by Shin-Etsu Chemical Co., Ltd.) with 100 parts by mass of a 10 mass% aqueous solution obtained by dissolving a polyvinyl alcohol binder (EXCEVAL AQ-4104 manufactured by Kuraray Co., Ltd.) in water.

<Comparative Example 2-4>

Base paper for vapor deposition paper was obtained in the same manner as in Example 2-1 except that no resin layer was formed.

<Example 3-1>

A clay coat layer coating liquid was prepared by mixing 80 parts by mass of kaolin (Contour Xtreme manufactured by IMERYS, aspect ratio: 33, average particle diameter d50: 0.26 pm) and 20 parts by mass (solid content) of a polylactic acid emulsion (LANDY PL-3000 manufactured by Miyoshi Oil & Fat Co., Ltd.). The clay coat layer coating liquid was applied to a glossy surface of one-side glazed paper (hardwood material ratio: 100%, Stockigt sizing degree: 9 seconds, basis weight: 50 g/m$^2$, thickness: 60 pm, density: 0.83 g/cm$^3$, Oken type smoothness: 430 seconds) with a Mayer bar, and dried at 120°C for 1 minute to form a clay coat layer (12 g/m$^2$, thickness: 4.6 pm). Next, the clay coat layer was coated, by using a Mayer bar, with a polylactic acid emulsion (LANDY PL-3000 manufactured by Miyoshi Oil & Fat Co., Ltd.) and dried at 120°C for 1 minute to form a resin layer (2 g/m$^2$, thickness: 2 pm), thereby obtaining base paper for vapor deposition paper (67 pm).

<Example 3-2>

Base paper for vapor deposition paper was obtained in the same manner as in Example 3-1 except that a styrene-(meth)acrylic resin (Joncryl HSL-9012 manufactured by BASF) was used instead of the polylactic acid emulsion for the clay coat layer, and a resin layer (1.5 g/m$^2$) was formed using a resin layer coating liquid prepared by mixing 0.15 parts by mass of 3-aminopropyltriethoxysilane (KBE-903 manufactured by Shin-Etsu Chemical Co., Ltd.) with 100 parts by mass of an aqueous dispersion liquid of a polyurethane-based resin binder having an oxygen permeability (23°C, 50% RH) of 2.0 mL/(m$^2$·day·atm) at a thickness of 25 pm (TAKELAC WPB-341 manufactured by Mitsui Chemicals, Inc., glass transition temperature: 130°C, solid content concentration: 30%) instead of the polylactic acid emulsion for the resin layer.

<Example 3-3>

Base paper for vapor deposition paper was obtained in the same manner as in Example 3-1 except that the resin layer coating liquid in Example 3-2 was used instead of the resin layer coating liquid in Example 3-1 and a coating amount of the resin layer was changed to 4 g/m$^2$.

<Comparative Example 3-1>

Base paper for vapor deposition paper was obtained in the same manner as in Example 3-1 except that an amount of kaolin for a clay coat layer was changed to 85 parts, a resin for the clay coat layer was changed to 15 parts by mass of a styrene-butadiene copolymer latex (A-6160 manufactured by Asahi Kasei Corporation), a coating amount of the clay coat layer was changed to 20 g/m$^2$, a resin for a resin layer was changed to an acrylic resin (ALMIC W manufactured by Dainichiseika Color & Chemicals Manufacturing Co., Ltd.), and a coating amount of the resin layer was changed to 4 g/m$^2$.

<Evaluation of Base Paper for Vapor Deposition Paper>

The base paper for vapor deposition paper obtained in each of Examples and Comparative Examples was evaluated as follows.

[Wetting Tension]

The wetting tension of the surface of the resin layer was measured in conformity with JIS K 6768:1999 at a measurement temperature of 23°C using a wetting reagent (a mixed liquid for a wetting tension test manufactured by Kanto Chemical Co., Inc.).

[Print-surf Surface Roughness]

The print-surf surface roughness of the surface of the resin layer was measured in conformity with JIS P 8151:2004 using a print-surf surface roughness tester manufactured by Lorentzen & Wettre.

[Cobb Water Absorption]

A test was performed in conformity with JIS P 8140:1998. Water (distilled water) was brought into contact with the surface of the resin layer of the base paper for vapor deposition paper at a water temperature of 23°C for a contact time of 120 seconds.

[Water Resistance]

Distilled water at 60°C was dropped onto the surface of the resin layer of the base paper for vapor deposition paper and held for 1 minute, then water droplets were wiped off, and a state of the surface of the resin layer was examined by touching with a hand. Evaluation was performed according to the following evaluation criteria.

A: no stickiness and no dissolution
B: stickiness and dissolution

[Contact Angle]

Using a dynamic contact angle measuring device DAT 1100 manufactured by MATSUBO Corporation, 4 pL of distilled water was dropped onto the surface of the resin layer of the base paper for vapor deposition paper. The contact angle was measured 60 seconds after a drop of water came into contact with the surface of the resin layer in conformity with JIS R 3257:1999 at a measurement temperature of 23°C.

[Surface Specific Electric Resistance]

The surface specific electric resistance of the surface of the resin layer was measured in conformity with JIS C 2139:2008.

[Biodegradable Material Ratio]

The biodegradable material ratio was calculated based on the following formula 1. In the following formula 1, a mass of the paper substrate means a mass excluding an inorganic content (filler and the like). The inorganic content is defined as a proportion of an ash content obtained by burning the paper to the weight of the paper substrate. When the value is 90% or more, it means that 90 mass% or more of the component in the base paper for vapor deposition paper, excluding an inorganic material, is the biodegradable material. Whether the material is a biodegradable material is determined by performing component analysis.

$$\text{Formula 1: ((mass of paper substrate + total mass of resin in clay coat layer}$$
$$+ \text{ total mass of resin in resin layer) - mass of non-biodegradable resin in clay coat}$$
$$\text{layer - mass of non-biodegradable resin in resin layer)/(mass of paper substrate +}$$
$$\text{total mass of resin in clay coat + total mass of resin in resin layer)} \times 100$$

[Biodegradation Degree]

The base paper for vapor deposition paper obtained in each of Examples and Comparative Examples was subjected to a biodegradation test for two years in conformity with JIS K 6955:2017 to measure the biodegradation degree. When the biodegradation degree is 85% or more in a shorter period, the biodegradation degree may be evaluated in a shorter period.

[Glass Transition Temperature]

Apart of the resin layer of the base paper for vapor deposition was scraped off, and a glass transition temperature was measured in conformity with JIS K 7121:1987. The glass transition temperature was shown in Table 1-1 as Glass transition temperature of resin contained in resin layer.

<Production of Vapor Deposition Paper>

An aluminum vapor deposition layer (thickness: 50 nm) was formed on the resin layer of the base paper for vapor deposition paper obtained in each of Examples 1-1 to 1-3 and 2-1 to 2-4 and Comparative Examples 1-1 to 1-4 and 2-1 to 2-5. The aluminum vapor deposition layer was coated, by using a Mayer bar, with an aqueous dispersion liquid of a polyurethane-based resin binder having an oxygen permeability (23°C, 50% RH) of 2.0 mL/(m$^2$·day·atm) at a thickness of 25 pm (TAKELAC WPB-341 manufactured by Mitsui Chemicals, Inc.) and dried at 120°C for 1 minute to form an overcoat layer (0.5 g/m$^2$, thickness: 0.5 pm). Further, the overcoat layer was coated, by using a Mayer bar, with an aqueous dispersion liquid of an ethylene-acrylic acid copolymer ammonium salt (manufactured by Sumitomo Seika Chemicals Co., Ltd., effective content: 29.2 mass%, copolymerization ratio of ZAIKTHENE AC and acrylic acid: 20 mol%, melting point: 95°C) was diluted with water such that the effective content was 20 mass%, and then dried at 120°C for 1 minute to form a heat seal layer (5 pm), thereby obtaining vapor deposition paper. The polyurethane-based resin used for the resin layer and the overcoat layer was subjected to $^1$H-NMR measurement. As a result, a content of the structural unit derived from meta-xylylene diisocyanate with respect to a total amount of structural units derived from a polyisocyanate was 50 mol% or more.

<Production of Vapor Deposition Paper>

An aluminum vapor deposition layer (thickness: 50 nm) was formed on the resin layer of the base paper for vapor deposition paper obtained in each of Examples 3-1 to 3-3 and Comparative Example 3-1. The aluminum vapor deposition layer was coated, by using a Mayer bar, with an aqueous dispersion liquid of a polyurethane-based resin binder having an oxygen permeability (23°C, 50% RH) of 2.0 mL/(m$^2$·day·atm) at a thickness of 25 pm (TAKELAC WPB-341 manufactured by Mitsui Chemicals, Inc.) and dried at 120°C for 1 minute to form an overcoat layer (0.5 g/m$^2$, thickness: 0.5 pm), thereby obtaining vapor deposition paper. The polyurethane-based resin used for the resin layer and the overcoat layer was subjected to $^1$H-NMR measurement. As a result, a content of the structural unit derived from meta-xylylene diisocyanate with respect to a total amount of structural units derived from a polyisocyanate was 50 mol% or more.

<Evaluation of Vapor Deposition Paper>

[Oxygen Permeability]

The oxygen permeability of the vapor deposition paper was measured using an oxygen permeability measuring device (OX-TRAN 2/22 manufactured by MOCON) under conditions of a temperature of 23°C and a relative humidity of 50%. Specifically, a surface of the overcoat layer of the vapor deposition paper was coated, in an amount of 5 g/m$^2$, with an isocyanate-based adhesive (manufactured by DIC Corporation, 1 part of Dick Dry KW-75 mixed with 10 parts of Dick Dry LX-500), and then a CPP film (GP-32 manufactured by Hokuetsu Kasei Co., Ltd.) having a thickness of 20 pm was attached thereto to form a laminated sheet. The oxygen permeability of the laminated sheet was measured in conformity with JIS K 7126-2:2006 at a temperature of 23°C and a relative humidity of 50%. The lower the value of the oxygen permeability, the better the oxygen barrier property.

[Water Vapor Permeability]

The water vapor transparency was measured in conformity with a JIS Z 0208:1976 (dish method) B method (temperature: 40°C±0.5°C, relative humidity: 90%±2%), with the overcoat layer of the vapor deposition paper disposed on an inner side (a low humidity side). The lower the water vapor permeability, the better the water vapor barrier property.

[Heat Seal Peel Strength]

A set of vapor deposition paper was stacked such that the heat seal layers faced each other, and heat-sealed using a heat seal tester (TP-701-B manufactured by Tester Sangyo Co., Ltd.) under conditions of 160°C, 0.2 MPa, and 1 second. Subsequently, the heat-sealed test piece was cut to have a width of 15 mm, and peeled off in a T-shape manner at a tensile speed of 300 mm/min using a tensile tester (RTC-1250A manufactured by A & D Company), and the recorded maximum load was taken as the heat seal peel strength.

[Barrier Packaging Suitability]

The vapor deposition paper evaluated by the above method was evaluated for suitability as barrier packaging according to the following criteria. The evaluation criteria are as follows.

A: The oxygen permeability is 1 mL/(m$^2$·day·atm) or less, the water vapor permeability is 1 g/(m$^2$·day) or less, and the heat seal peel strength is 2 N/15 mm or more
B: The oxygen permeability is 1 mL/(m$^2$·day·atm) or more, the water vapor permeability is 1 g/(m$^2$·day) or more, or the heat seal peel strength is less than 2 N/15 mm

[Recyclability (Pulp Recovery Rate after Re-disintegration)]

The obtained vapor deposition paper was disintegrated in conformity with JIS P 8220-1:2012. At this time, 10 minutes after the start of disintegration, the dispersion liquid was treated with a vibrating flat screen provided with a 6-cut screen, samples on the 6-cut screen (opening: 0.15 mm) were collected and dried to calculate a mass ratio (%) of the residue, and a value obtained by subtracting the mass ratio (%) of the residue from 100% was taken as a pulp recovery rate (%) after re-disintegration and used as an index of the recyclability.

Table 1-1

| | | Example 1-1 | Example 1-2 | Example 1-3 | Comparative Example 1-1 | Comparative Example 1-2 | Comparative Example 1-3 | Comparative Example 1-4 |
|---|---|---|---|---|---|---|---|---|
| Base paper for vapor deposition paper | Coated surface | Glossy surface | Glossy surface | Glossy surface | Glossy surface | Glossy surface | Glossy surface | Rough surface |
| | Clay coat layer | Kaolin/ styrene-(meth) acrylic resin | Kaolin/ styrene-(meth) acrylic resin | Kaolin/ styrene-(meth) acrylic resin | Kaolin/ styrene-(meth) acrylic resin | Kaolin/ styrene-(meth) acrylic resin | Kaolin/ styrene-(meth) acrylic resin | Kaolin/ styrene-(meth) acrylic resin |
| | Resin layer | Urethane-based resin | Urethane-based resin | Polyester-based resin | Ethylene-acrylic acid copolymer | Styrene-(meth) acrylic resin | No | Polyester-based resin |
| | Glass transition temperature [°C] of resin contained in resin layer | 130 | 130 | 65 | 80 | 5 | - | 65 |
| | Wetting tension [mN/m] | 62 | 59 | 55 | 39 | 42 | 58 | 56 |
| | Print-surf surface roughness [$\mu$m] | 0.87 | 0.90 | 0.88 | 0.84 | 0.88 | 1.4 | 2.7 |
| | Cobb water absorption [g/m$^2$] of surface of resin layer | 0.5 | 0.90 | 0.4 | 0.3 | 0.8 | 0.9 | 0.6 |
| | Water contact angle [°] on surface of resin layer | 57.3 | 58.1 | 52.0 | 74.2 | 67.7 | 62.7 | 50.0 |
| | Biodegradation degree [%] | 90 | 92 | 90 | 82 | 81 | 92 | 90 |
| | Water resistance | A | A | A | A | A | B | A |
| | Surface specific electric resistance [$\times 10^{14}$ $\Omega$] | 2.3 | 2.5 | 2.2 | 10.2 | 18.8 | 0.02 | 0.5 |

(continued)

|  |  | Example 1-1 | Example 1-2 | Example 1-3 | Comparative Example 1-1 | Comparative Example 1-2 | Comparative Example 1-3 | Comparative Example 1-4 |
|---|---|---|---|---|---|---|---|---|
| Vapor deposition paper | Oxygen permeability [mL/ (m²·day·atm)] | 0.1 | 0.2 | 0.4 | 99.5 | 146 | 2000< | 4.4 |
|  | Water vapor permeability [g/ (m²·day)] | 0.3 | 0.5 | 0.8 | 7.2 | 71.2 | 253 | 7.6 |
|  | Heat seal peel strength [N/15 mm] | 3 | 3 | 3 | 3 | 3 | 3 | 3 |
|  | Barrier packaging suitability | A | A | A | B | B | B | B |
|  | Recyclability (pulp recovery rate after re-disintegration) [%] | 88 | 89 | 88 | 70 | 70 | 90 | 88 |

Table 1-2

| | | Example | | | | Comparative Example | | | |
|---|---|---|---|---|---|---|---|---|---|
| | | 2-1 | 2-2 | 2-3 | 2-4 | 2-1 | 2-2 | 2-3 | 2-4 |
| Base paper for vapor depositio n paper | Resin layer | Polyurethane-based resin | Polyurethane-based resin | Polylactic acid | Hydroxy group-containing polyurethane-based resin | Ethylene-acrylic acid copolymer | Styrene-(meth) acrylic resin | PVA | No |
| | Glass transition temperature [°C] of resin contained in resin layer | 130 | 130 | 20 | 40 | 80 | 5 | - | - |
| | Wetting tension [mN/m] | 62 | 59 | 55 | 58 | 39 | 42 | 24 | 48 |
| | Print-surf surface roughness [$\mu$m] | 0.87 | 0.90 | 0.88 | 0.92 | 0.84 | 0.88 | 0.89 | 2.7 |
| | Cobb water absorption [g/m$^2$] of surface of resin layer | 0.5 | 0.9 | 0.4 | 0.7 | 0.3 | 0.8 | 1 (partially eluted in water) | 7.9 |
| | Water contact angle [°] on surface of resin layer | 57.3 | 58.1 | 56.0 | 54.3 | 74.2 | 67.7 | 33.0 | 62.7 |
| | Biodegradation degree [%] | 90 | 92 | 99 | 90 | 82 | 81 | 90 | 92 |
| | Water resistance | A | A | A | A | A | A | B | A |
| | Surface specific electric resistance [$\times 10^{14}$ $\Omega$] | 2.3 | 2.5 | 1.5 | 1.8 | 10.2 | 18.8 | 3.5 | 0.02 |

(continued)

| | | Example | | | | Comparative Example | | | |
|---|---|---|---|---|---|---|---|---|---|
| | | 2-1 | 2-2 | 2-3 | 2-4 | 2-1 | 2-2 | 2-3 | 2-4 |
| Vapor depositio n paper | Oxygen permeability [mL/(m$^2$·day·atm)] | 0.1 | 0.2 | 0.8 | 0.1 | 99.5 | 146 | 0.3 | 2000< |
| | Water vapor permeability [g/ (m$^2$·day)] | 0.3 | 0.5 | 0.8 | 0.5 | 7.2 | 71.2 | 2.0 | 2000< |
| | Heat seal peel strength [N/15 mm] | 3 | 3 | 3 | 3 | 3 | 3 | 3 | 3 |
| | Barrier packaging suitability | A | A | A | A | B | B | B | B |
| | Recyclability (pulp recovery rate after re-disintegration) [%] | 88 | 89 | 90 | 88 | 70 | 70 | 85 | 90 |

Table 1-3

| | | | Example 3-1 | Example 3-2 | Example 3-3 | Comparative Example 3-1 |
|---|---|---|---|---|---|---|
| Base paper for vapor deposition paper | Paper substrate | | One-side glazed paper 50 g/m$^2$ | One-side glazed paper 50 g/m$^2$ | One-side glazed paper 50 g/m$^2$ | One-side glazed paper 50 g/m$^2$ |
| | Cay coat layer | Resin to be used | Polylactic acid | Styrene-(meth) acrylic resin | Polylactic acid | Styrene-butadiene copolymer |
| | | Total amount of resin | 2.4 g/m$^2$ | 2.4 g/m$^2$ | 2.4 g/m$^2$ | 3 g/m$^2$ |
| | | Amount of non-biodegradable resin | 0 g/m$^2$ | 2.4 g/m$^2$ | 0 g/m$^2$ | 3 g/m$^2$ |
| | Resin layer | Resin to be used | Polylactic acid | Urethane | Urethane | Acrylic |
| | | Glass transition temperature [°C] of resin contained in resin layer | 20 | 130 | 130 | 20 |
| | | Total amount of resin | 2 g/m$^2$ | 1.5 g/m$^2$ | 4 g/m$^2$ | 4 g/m$^2$ |
| | | Amount of non-biodegradable resin | 0 g/m$^2$ | 1.5 g/m$^2$ | 4 g/m$^2$ | 4 g/m$^2$ |
| | Total amount of non-biodegradable resin | | 0 g/m$^2$ | 3.9 g/m$^2$ | 4 g/m$^2$ | 7 g/m$^2$ |
| | Wetting tension [mN/m] | | 55 | 62 | 62 | 39 |
| | Print-surf surface roughness [um] | | 0.88 | 0.87 | 0.76 | 0.74 |
| | Cobb water absorption [g/m$^2$] of surface of resin layer | | 0.4 | 0.5 | 0.2 | 0.3 |
| | Water contact angle [°] on surface of resin layer | | 56 | 57.3 | 58 | 74.2 |
| | Biodegradable material ratio [%] | | 100 | 93 | 92 | 88 |
| | Biodegradation degree [%] | | 99 | 90 | 90 | 82 |
| | Water resistance | | A | A | A | A |
| | Surface specific electric resistance [$\times 10^{14}\ \Omega$] | | 1.5 | 2.3 | 2.4 | 16.5 |
| Vapor deposition paper | Oxygen permeability [mL/ (m$^2$·day·atm)] | | 0.8 | 0.1 | 0.1 | 2.0 |
| | Water vapor permeability [g/ (m$^2$·day)] | | 0.8 | 0.3 | 0.3 | 3.0 |
| | Barrier packaging suitability | | A | A | A | B |
| | Recyclability (pulp recovery rate after re-disintegration) [%] | | 90 | 88 | 85 | 70 |

The vapor deposition paper produced using the base paper for vapor deposition paper in each of Examples had both a lower oxygen permeability and a lower water vapor permeability and had excellent barrier properties, as compared with the vapor deposition paper produced using the base paper for vapor deposition paper in each of Comparative Examples.

**Claims**

1. Base paper for vapor deposition paper, the base paper comprising:

   a paper substrate; and
   a clay coat layer and a resin layer in this order on at least one surface of the paper substrate, wherein
   a surface of the resin layer has a wetting tension of 50 mN/m or more as measured in conformity with JIS K 6768:1999 and a print-surf surface roughness of 2.5 pm or less as measured in conformity with JIS P 8151:2004.

2. The base paper for vapor deposition paper according to claim 1, wherein

   the surface of the resin layer has a Cobb water absorption of 0 g/m$^2$ or more and 10 g/m$^2$ or less at a temperature of 23°C and a contact time of 120 seconds, as measured in conformity with JIS P 8140:1998, and
   a contact angle of the surface of the resin layer to water after 60 seconds is 65° or less as measured in conformity with JIS R 3257:1999.

3. The base paper for vapor deposition paper according to claim 1 or 2, wherein
   the surface of the resin layer has a surface specific electric resistance of $0.1 \times 10^{14}$ Ω or more and $10 \times 10^{14}$ Ω or less as measured in conformity with JIS C 2139:2008.

4. The base paper for vapor deposition paper according to any one of claims 1 to 3, wherein
   a biodegradation degree is 85% or more as measured in conformity with JIS K 6955:2017.

5. The base paper for vapor deposition paper according to any one of claims 1 to 4, wherein
   90 mass% or more of a component in the base paper for vapor deposition paper, excluding an inorganic material, is a biodegradable material.

6. The base paper for vapor deposition paper according to any one of claims 1 to 5, wherein
   the resin layer contains a water-suspendable polymer, and the water-suspendable polymer is one or more selected from the group consisting of a polyester-based resin and a polyurethane-based resin.

7. The base paper for vapor deposition paper according to any one of claims 1 to 6, wherein
   the clay coat layer contains an inorganic pigment and a binder, and the inorganic pigment has an aspect ratio of 50 or less and an average particle diameter of 5 pm or less.

8. The base paper for vapor deposition paper according to claim 7, wherein
   the inorganic pigment is kaolin.

9. The base paper for vapor deposition paper according to claim 7 or 8, wherein
   the binder contained in the clay coat layer is one or more selected from the group consisting of a styrene-butadiene-based resin, a styrene-(meth)acrylic resin, olefin-unsaturated carboxylic acid-based copolymer, and polylactic acid.

10. The base paper for vapor deposition paper according to any one of claims 1 to 9, wherein
    the clay coat layer and the resin layer are formed using an aqueous medium.

11. Vapor deposition paper comprising:

    the base paper for vapor deposition paper according to any one of claims 1 to 10; and
    a vapor deposition layer, an overcoat layer, and, if necessary, a heat seal layer in this order on the resin layer of the base paper for vapor deposition paper.

## INTERNATIONAL SEARCH REPORT

International application No.

**PCT/JP2021/046272**

### A. CLASSIFICATION OF SUBJECT MATTER

***D21H 19/36***(2006.01)i; ***B32B 7/02***(2019.01)i; ***B32B 27/10***(2006.01)i; ***B32B 27/30***(2006.01)i; ***B32B 27/36***(2006.01)i;
***B32B 27/40***(2006.01)i; ***B65D 65/40***(2006.01)i; ***D21H 19/08***(2006.01)i; ***D21H 19/28***(2006.01)i; ***D21H 19/40***(2006.01)i;
***D21H 27/30***(2006.01)i
FI: D21H19/36 Z; D21H19/08; B32B7/02; B32B27/36; B32B27/40; B32B27/30 B; B32B27/30 A; B65D65/40 D BRH;
D21H19/28; B32B27/10; D21H27/30 A; D21H19/40

According to International Patent Classification (IPC) or to both national classification and IPC

### B. FIELDS SEARCHED

Minimum documentation searched (classification system followed by classification symbols)

D21H19/00-19/84; D21H27/30; B32B1/00-43/00; B65D65/40

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2004-204366 A (TOPPAN PRINTING CO LTD) 22 July 2004 (2004-07-22)<br>entire text | 1-11 |
| A | WO 2017/170462 A1 (NIPPON PAPER INDUSTRIES CO., LTD.) 05 October 2017<br>(2017-10-05)<br>entire text | 1-11 |
| A | JP 2013-79470 A (TECHNO WORLD:KK) 02 May 2013 (2013-05-02)<br>entire text | 1-11 |
| A | JP 61-124693 A (HONSHU PAPER CO LTD) 12 June 1986 (1986-06-12)<br>entire text | 1-11 |
| A | JP 7-295475 A (HONSHU PAPER CO LTD) 10 November 1995 (1995-11-10)<br>entire text | 1-11 |

☑ Further documents are listed in the continuation of Box C.    ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **17 January 2022** | **25 January 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

| International application No. |
| --- |
| **PCT/JP2021/046272** |

### C.    DOCUMENTS CONSIDERED TO BE RELEVANT

| Category* | Citation of document, with indication, where appropriate, of the relevant passages | Relevant to claim No. |
| --- | --- | --- |
| A | JP 2016-74900 A (PRIME POLYMER CO LTD) 12 May 2016 (2016-05-12)<br>entire text | 1-11 |
| A | JP 2019-171863 A (DAINIPPON PRINTING CO LTD) 10 October 2019 (2019-10-10)<br>entire text | 1-11 |
| A | JP 2017-226186 A (DAINIPPON INK & CHEMICALS) 28 December 2017 (2017-12-28)<br>entire text | 1-11 |
| A | JP 2-234996 A (KANZAKI PAPER MFG CO LTD) 18 September 1990 (1990-09-18)<br>entire text | 1-11 |
| A | JP 2019-167683 A (NIPPON PAPER INDUSTRIES CO., LTD.) 03 October 2019<br>(2019-10-03)<br>entire text | 1-11 |
| A | JP 2011-63899 A (DAIO PAPER CORP) 31 March 2011 (2011-03-31)<br>entire text | 1-11 |
| A | WO 2015/016069 A1 (MITSUI CHEMICALS, INC) 05 February 2015 (2015-02-05)<br>entire text | 1-11 |
| A | JP 2020-521654 A (TETRA LAVAL HOLDINGS & FINANCE S.A) 27 July 2020<br>(2020-07-27)<br>entire text | 1-11 |
| A | WO 2019/239334 A1 (STORA ENSO OYJ) 19 December 2019 (2019-12-19)<br>entire text | 1-11 |
| A | JP 2003-291296 A (ISHIDA CO LTD) 14 October 2003 (2003-10-14)<br>entire text | 1-11 |
| A | WO 2019/069963 A1 (NIPPON PAPER INDUSTRIES CO., LTD.) 11 April 2019<br>(2019-04-11)<br>entire text | 1-11 |

Form PCT/ISA/210 (second sheet) (January 2015)

## INTERNATIONAL SEARCH REPORT
### Information on patent family members

| International application No. |
| --- |
| **PCT/JP2021/046272** |

| Patent document cited in search report | | | Publication date (day/month/year) | Patent family member(s) | | | Publication date (day/month/year) |
| --- | --- | --- | --- | --- | --- | --- | --- |
| JP | 2004-204366 | A | 22 July 2004 | (Family: none) | | | |
| WO | 2017/170462 | A1 | 05 October 2017 | US | 2019/0270289 | A1 | |
| | | | | EP | 3437860 | A1 | |
| | | | | AU | 2017244605 | A | |
| | | | | KR | 10-2018-0126516 | A | |
| | | | | CN | 109070563 | A | |
| JP | 2013-79470 | A | 02 May 2013 | (Family: none) | | | |
| JP | 61-124693 | A | 12 June 1986 | (Family: none) | | | |
| JP | 7-295475 | A | 10 November 1995 | (Family: none) | | | |
| JP | 2016-74900 | A | 12 May 2016 | US | 2017/0305127 | A1 | |
| | | | | WO | 2016/056524 | A1 | |
| | | | | EP | 3205498 | A1 | |
| | | | | TW | 201623405 | A | |
| | | | | AU | 2015329163 | A | |
| | | | | KR | 10-2017-0060126 | A | |
| | | | | CN | 107107595 | A | |
| JP | 2019-171863 | A | 10 October 2019 | (Family: none) | | | |
| JP | 2017-226186 | A | 28 December 2017 | (Family: none) | | | |
| JP | 2-234996 | A | 18 September 1990 | (Family: none) | | | |
| JP | 2019-167683 | A | 03 October 2019 | (Family: none) | | | |
| JP | 2011-63899 | A | 31 March 2011 | (Family: none) | | | |
| WO | 2015/016069 | A1 | 05 February 2015 | US | 2016/0159965 | A1 | |
| | | | | EP | 3029082 | A1 | |
| | | | | CN | 105408378 | A | |
| | | | | TW | 201509976 | A | |
| JP | 2020-521654 | A | 27 July 2020 | US | 2020/0094536 | A1 | |
| | | | | WO | 2018/220132 | A1 | |
| | | | | EP | 3409463 | A1 | |
| | | | | CN | 110678325 | A | |
| | | | | BR | 112019024995 | A | |
| WO | 2019/239334 | A1 | 19 December 2019 | EP | 3807462 | A1 | |
| | | | | CN | 112368443 | A | |
| | | | | SE | 1850719 | A1 | |
| JP | 2003-291296 | A | 14 October 2003 | (Family: none) | | | |
| WO | 2019/069963 | A1 | 11 April 2019 | US | 2020/0269554 | A1 | |
| | | | | EP | 3686007 | A1 | |
| | | | | KR | 10-2020-0061347 | A | |
| | | | | CN | 111278650 | A | |
| | | | | AU | 2018345211 | A | |
| | | | | TW | 201927574 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4065599 A
- JP 7223686 A

- WO 2015016069 A